# EUROPEAN PATENT APPLICATION

(11) **EP 2 530 187 A1**
(43) Date of publication of application: **05.12.2012**
(21) Application number: 11168723.2
(22) Date of filing: 03.06.2011
(51) Int. Cl.: C30B 11/00, C30B 29/06, C01B 33/037, H01L 31/18

(54) **Refining of silicon by directional solidification in an oxygen-containing atmosphere**

(71) Applicant: Evonik Solar Norge AS, 7041 Trondheim (NO)
(72) Inventor: Nygaard, Lars, 7563 MALVIK (NO); Sörvik, Arvid Inge, 7500 STJÖRDAL (NO); Sylten, Brynjar, 7027 TRONDHEIM (NO); Kvande, Rannveig, 7027 RANHEIM (NO); Hugo, Franz, 63743 ASCHAFFENBURG (DE)
(74) Representative: Bendele, Tanja

(57) **Abstract**

There is provided a refining method for silicon by directional solidification, wherein a silicon melt is added to a mould which is subsequently cooled from below to generate a bottom-up solidification, characterized in that the bottom-up solidification is carried out in an atmosphere of air.

## Description

### Technical field

The present disclosure relates to the field of production of solar grade silicon. In particular, it relates to the refinement of liquid silicon by directional solidification.

### Background

There is a growing demand for solar cell panels, partly due to the concerns about global warming. Accordingly, there is also a growing demand for a cost-efficient and environmentally friendly (i.e. energy-efficient) method for preparing the silicon needed to produce the solar cell panels.

There are several ways of producing silicon. Among these are:
A chemical method involving acid treatment of metallurgical silicon followed by a gas phase reaction with HCl and gas phase decomposition on silicon rods with hydrogen. This chemical method, known as the Siemens Process, consumes high amounts of energy and is thus expensive.
A physical purification method involving refining semi-pure liquid silicon with slag and gas followed by solidification. The solid product is crushed and Fe, Al, Ca and Ti are leached out. The product is then re-melted and subjected to directional solidification. This method is used by the Elkem company.

In a third method, pure quartz is subjected to carbothermic reduction to obtain a silicon liquid, which may be refined by the following steps; gas refining, temperature adjustment, settling, filtering, skimming and directional solidification. A challenge using this method is to produce a silicon product of sufficient purity.

The directional solidification may for example be performed as in WO 2009/153152, which describe a method comprising a step of transferring a metallurgical grade-silicon into a crucible in an atmosphere of an inert gas, a step of directional solidification by removing heat from the bottom of the crucible in an atmosphere of an inert gas, and a step of obtaining a silicon ingot (the product of the method) from the quartz crucible.

### Summary

The inventors have realized that a method based on a carbothermic reduction of quartz to liquid silicon followed by refining in the liquid state is a promising alternative for the production of solar grade silicon as it may allow for low investment costs, low operational costs and low energy consumption compared to state of the art as per today. The refining includes directional solidification of the silicon liquid. More importantly, the inventors have surprisingly found that the cumbersome steps of establishing and maintaining an inert atmosphere in the process of directional solidification are unnecessary. The inventors have thus found a way to reduce the complexity of the processes involved in the production of solar grade silicon. Thereby, the process is made more efficient and less expensive.

Thus, there is provided refining method to produce solar grade silicon, wherein a silicon melt is added to a mould which is subsequently heated from above and cooled from below to generate a bottom-up solidification, characterized in that the bottom-up solidification is carried out in an oxygen-containing atmosphere.

### Brief description of the figures

Figure 1 shows an embodiment of a system for producing solar cellgrade silicon.
Figure 2 shows an embodiment of a device for carrying out a directional solidification according to the present disclosure.

### Detailed description

Thus, there is provided refining method to produce solar grade silicon, wherein a silicon melt is added to a mould which is subsequently heated from above and cooled from below to generate a bottom-up solidification. The method is characterized in that the bottom-up solidification is carried out in an oxygen-containing atmosphere.

In the context of the present disclosure, an "oxygen-containing atmosphere" refers to an atmosphere comprising at least 1 % oxygen. The skilled person understands that level of oxygen in the atmosphere of the directional solidification may decrease over the course of the process as some oxygen may be consumed. As discussed herein, such reactions with the oxygen will however not degrade the not the quality of the silicon to a substantial degree. as some oxygen may be consumed. In embodiments of the present disclosure, the oxygen-containing atmosphere may for example comprise at least 2 %, such as at least 5 % or as at least 10 %, oxygen during the whole process. The atmosphere in the beginning of the process may for example be air, which comprises about 21 % oxygen.

The mould employed in the method may for example be a crucible.

The mould/crucible used in directional solidifications normally has a cast area of less than 1 m². However, in a large scale production according to the present disclosure, the cast area of the mould/crucible may for example be 1-4 m². Here, the cast area refers to the cross sectional-area of the mould when viewed from above.

Preferably, the addition of the liquid silicon to the crucible/mould is carried out in an oxygen-containing atmosphere, such as air. Such addition may take place outside a chamber in which the directional solidification takes place. Thus, protective inert gas is normally not provided during the filling or the solidification.

The liquid silicon added in the method may for example be obtained from a carbothermic reduction of quartz or from upgraded metallurgical grade silicon. Further, the liquid silicon may have been refined and filtered in the liquid state before is it subjected to the directional solidification.

For example, the liquid silicon may have been filtered for carbides and refined by gas extraction, e.g. with chlorine gas, optionally combined with an inert gas, such as argon. Such extraction removes aluminum (Al), calcium (Ca) and other elements capable of forming salts or slag with the chlorine gas under the prevailing conditions.

In the directional solidification, Iron (Fe), Al and other metals having a low distribution coefficient are separated from the solidifying silicon since they have a higher solubility in the melt. Thus, the directional solidification is also a step of refinement. The table below shows the result of a directional solidification of a silicon liquid obtained from a carbothermic reduction not followed by gas extraction with chlorine gas.

| Element | Before directional solidification (ppm (w/w)) | After directional solidification, in the center of the ingot (ppm (w/w)) | Removed by segregation |
|---|---|---|---|
| B | 0.45 | 0.425 | 6% |
| P | 1 | 0.545 | 46 % |
| Al | 250 | 1.75 | 99 % |
| Cu | 1.4 | 0.03 | 98 % |
| Fe | 160 | <0,05 | <99,97% |
| Ge | 0.58 | 0.58 | 0% |
| Na | 0.1 | 0.02 | 80 % |

Before the directional solidification, the liquid silicon may for example be added to the crucible or mould by pouring it from a ladle or an induction furnace directly into the crucible/mould. In such an embodiment, the pouring is preferably carried out in an atmosphere of air.

The cooling during the directional solidification may for example have an effect of at least 20 kW/m² cast area. The cast area is normally the same as the bottom area of the inside of the crucible/mould. The cooling media employed for the cooling is preferably air. The cooling media may be supplied below a plate arranged under the bottom of the crucible/mould. Such a plate may be part of a device for the directional solidification. Alternatively, the bottom plate may be a non-fixed object on which the crucible is transferred into a device for directional solidification. The bottom plate and the crucible/mould may for example be composed of silicon carbide, silica, quartz or another pure heat resistant material with the required heat conductivity. The bottom plate and the crucible/mould can be varied in size to cover a cast area from one equal to a G5 ingot (0.70 m²) up to 4.0 m².

During the cooling, heat is conducted through the bottom of the crucible/mould and, if applicable, through a plate or another construction arranged under the crucible/mould, to the cooling medium. It has been found that an efficient cooling may be obtained if the thermal conductivity in the layers between the silicon at the bottom of the crucible/mould and the cooling media is at least 0.75 W/°K, such as at least 0.85 W/°K. Here, it is referred to the combined thermal conductivity of all layers involved. The dimensions and material of the crucible/mould and any other construction between the crucible/mould and the cooling media may be selected accordingly.

To obtain a flat to slightly convex shape of the solidification front the side walls of the mould/crucible including the supporting structure preferably have a low thermal conductivity. An efficient refining may be obtained if the thermal conductivity of the side wall construction is lower than 0.75 W/°K in sum of all layers involved such as at least lower than 0.80 W/°K.

The silicon liquid is heated from from above during at least part of the bottom-up directional solidification process. In this manner, the bottom-up solidification process may be more accurately controlled. Preferably, the silicon liquid is heated from above during the whole bottom-up directional solidification process. The degree of heating may also changed over the course of the directional solidification process. For example, the degree of heating may be decreased as an increasing portion of the silicon is solidified. For example, the top temperature of the furnace may be set close to the solidification temperature of the silicon at the end of the solidification process. Thus, more heating may be supplied in the beginning of the process than in the end of the process. In one embodiment, the heating effect during the process of directional solidification is 60-160 kW/m² cast area. In a more specific embodiment, the heating effect is 66 - 195kW/m² cast area.

A device for the directional solidification process may thus be provided with heating means. Preferably, such means are capable of supplying at least 166 kW/m² cast area, such as at least 195 kW/m² cast area. Such means shall tolerate an oxygen-containing atmosphere, also at high temperatures. In one embodiment, the heating element(s) employed for the heating is/are capable of reaching a temperature of at least 1700 °C, such as at least 1800 °C. Such heating elements may for example be MoSi₂ heating elements (e.g. KANTHAL Super). The MoSi₂ heating elements actually require an oxygen-containing atmosphere to reach such high temperatures. Thus, in prior art technologies, such as the disclosure of WO 2009/153152, wherein the directional solidification is carried out in an inert atmosphere, it is may be difficult, if not impossible to reach element temperatures over 1700 °C. Thus, there are limited possibilities to control the prior art processes of directional solidification as compared to the directional solidification process of the present disclosure.

The crucible/mould may be preheated before the silicon liquid is added to it.

The preheating may take place in the same device as the following directional solidification. In such an embodiment, the crucible may be preheated in the device and then filled with liquid silicon outside the device, and thereafter, the directional solidification of the liquid silicon in the crucible/mould is carried out in the device. Thus, only one device may be used for two different activities.

Alternatively, the preheating and directional solidification are carried out in two different devices. Such an embodiment may be beneficial in large scale production. In an industrial setting, a preheating device may be placed at a position downstream of one or more devices for directional solidification. As the directional solidification normally takes more time than the preheating, it may be beneficial to associate a plurality of devices for directional solidification with a single preheating device.

The crucible/mould is for example heated to at least 1000 °C, most preferred 1250 °C, before the liquid silicon is added. That is, the crucible/mould may have a temperature of at least 1000 °C when liquid silicon is added.

During the bottom-up directional solidification, the contaminants accumulate in the liquid phase and finally, when the solidification is completed, in the top layer of the resulting silicon ingot. Thus, the top layer is removed before the silicon is used as feedstock for production of solar cells. Further, the side layers and the bottom layer of the ingot may also be removed as they may contain impurities from the crucible/mould and coating. The top layer and optionally the other layers may be removed by the solar cell producer. However, the layer(s) is/are preferably removed by the party carrying out the directional solidification process. The layer(s) may for example be separated from the ingot by cutting or grinding. The thickness of the removed top layer may for example be 10-15 % of the height of the ingot before the removal(s). Likewise, the volume of the removed top layer may for example be 10-15 % of the volume of the ingot before the removal(s).

The thickness of a removed side layer may for example be 10-30 mm, such as about 20 mm. Likewise, the volume of the removed side layer may be reduced as % of the ingot volume if the cast area is increased. For a G5 ingot (840mm x 840mm) the side cut of 20 mm will represent 9.3% of the ingot volume before the removal while the same cut off from an ingot with a cast area of 2.0 m² will represent 5.9 % of ingot volume.

The thickness of a removed bottom layer may for example be 5-7 % of the height of the ingot before the removal(s). Likewise, the volume of a removed bottom layer may for example be 5-7 % of the volume of the ingot before the removal(s).

After the removal of the layer(s), the ingot may for example comprise less than 0.55 ppm (w/w), such as 0.3-0.55 ppm (w/w), boron. As seen in the table above, boron is not efficiently separated in the directional solidification. Neither is it efficiently removed by the chlorine gas extraction explained above. Thus, starting materials having low levels of boron may be selected for the carbothermic reduction reaction.

Further, the ingot may comprise less than 0.8 ppm (w/w) phosphorus after the removal of the layer(s). As seen in the table above, phosphorus is not efficiently separated in the directional solidification either. Neither is it efficiently removed by the chlorine gas extraction. Thus, starting materials having low levels of phosphorus may be selected for the carbothermic reduction process.

Further, the ingot may comprise less than 2 ppm (w/w) aluminum after the removal of the layer(s). As seen in the table above, aluminum is efficiently separated in the directional solidification.

Further, the ingot may comprise less than 0.1 ppm (w/w), such as less than 0.01 ppm (w/w), copper after the removal of the layer(s). As seen in the table above, copper is efficiently separated in the directional solidification.

Further, the ingot may comprise less than 0.05 ppm (w/w) sodium after the removal of the layer(s). As seen in the table above, sodium is efficiently separated in the directional solidification.

Further, the ingot may comprise less than 0.1 ppm (w/w), such as less than 0.05 ppm (w/w) calcium after the removal of the layer(s). Calcium is efficiently removed in the chlorine gas extraction.

Further, the ingot may comprise less than 0.05 ppm (w/w) iron after the removal of the layer(s). Iron is efficiently separated in the directional solidification.

Also, the ingot may comprise less than 0.05 ppm (w/w) titanium after the removal of the layer(s). Titanium is efficiently separated in the directional solidification.

The levels described above may also refer to the levels in the middle of the ingot, before or after the removal of the top layer and any other layer.

The removed top layer and the removed side layers may be recycled to a silicon production process, optionally after cleaning. For example, they may be recycled to the carbothermic reduction process producing the silicon melt which is subsequently refined.

### Examples

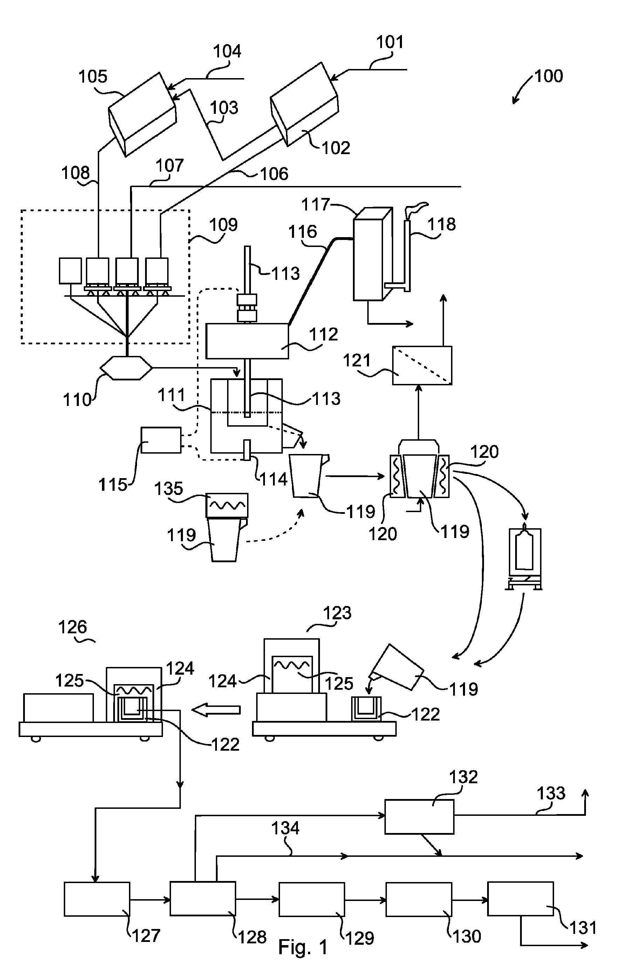

An exemplary system for production of solar grade silicon is described below with reference to figure 1.

Natural quartz 101 from a mine is added to a quartz processing plant 102, in which the natural quartz undergoes one or more of the steps of crushing, screening, milling, optical sorting, magnet separation, gravimetric separation, flotation and acidic treatment. Optical sorting comprises optical detection of impurities in the natural quartz. For example, the impurities may be visible as dark spots. Further, the optical sorting may comprise the removal of the pieces of material on which such spots have been detected by means of compressed air. That is, such pieces may be blown off a transport belt, such as a conveyor belt or the like. The acidic treatment may comprise dissolving and removing impurities. In the flotation pieces of material having different physiochemical surface properties than quartz are separated. The magnet separation comprises the removal of pieces of material containing magnetic minerals.

Some of the quartz 103 from the quartz processing plant 102 is added to a silicon carbide production plant 105, to which carbon black 104 of high purity is also added. Such carbon black may for example be derived from natural gas.

The same type of processed quartz 106 from the quartz processing plant 102 is added, together with recycled silicon metal 107 from downstream positions in the system and silicon carbide 108 from the silicon carbide production plant 105, to an arrangement for weighing and mixing 109.

The appropriately mixed material is then added to a
reduction furnace/reaction vessel 111 by means of charging equipment 110. The weight ratio of quartz to silicon carbide in the material added to the reduction furnace 111 is about 1.1:1. A smoke hood 112 is arranged above the reduction furnace 111 to collect gases formed during the reduction process. The collected gases are routed, via a duct 116, to a device for flue gas filtering and dust treatment 117. The device 117 comprises a chimney 118 through which the purified gases are expelled.

A first electrode 113, preferably composed of graphite, is arranged to extend into the reduction furnace 111 from above. A second electrode 114, also preferably composed of graphite, is arranged in the bottom of the reduction furnace. The first 113 and the second 114 electrode are connected to a power source 115, such as a DC or AC power source, for generating an electric arc that heats the carbothermic reduction process. The silicon melt formed in the reduction furnace 114 is tapped through a tapping zone of the reduction furnace 114 into a ladle 119, which has been preheated by a ladle preheating device 135. During the tapping, an inert gas, such as argon, may be bubbled through the ladle to stir the silicon melt therein. Material may be continuously added to the reduction furnace 111.

The filled ladle 119 is moved to an arrangement for chlorine refining, during which chlorine gas, optionally together with an inert gas, such as argon, is bubbled through the liquid silicon in the ladle 119 to react with impurities, such as aluminum or calcium, to form chloride salts, e.g. AlCl₃ and CaCl₂. The gases are then purified in a gas cleaning system 121. The arrangement for chlorine refining preferably comprises means for heating 120, such as inductive heating, of the liquid silicon. This is to ensure that the silicon remains liquid during the process.

The refined silicon melt is then, optionally after filtering, added to a preferably preheated crucible 122 on a device for directional solidification in filling position 123. The refined silicon may also be stored in an induction furnace or holding furnace for some time before being added to the preheated crucible 122. The silicon melt is added to the crucible without the use of any protective gas. The device comprises a furnace 124 having heating elements 125 (the crucible may for example have been preheated in the furnace 124). When the crucible 122 has been filled, the device for directional solidification is set to its processing position 126, in which the crucible 122 is placed in the furnace 124. During the processing, which is performed without the use of any protective gas such as argon, the crucible 122 is heated from above by the heating elements 125 and cooled from below to generate a controlled bottom-up solidification, which results in an accumulation of contaminants/impurities in the top layer of the formed solid silicon ingot.

The crucible 122 is then removed from the ingot in a crucible removal step 127. This normally involves breaking the crucible 122 to release the ingot. The ingot is then cut to remove the outermost layer of its sides and bottom as well as the contaminants-containing top layer in an ingot cutting step 128. The ingot may then be subjected to the steps of etching and washing 129, packing 130 and storage 131, before it is transported to a customer, which may recrystallize the ingot and then cut it to wafers for the production of solar cell panels.

All or some of the side and bottom layers removed in the ingot cutting step 128 are recycled to the process, preferably to the arrangement for weighing and mixing 109, after a step of milling, sandblasting and/or crushing 132. The top layer from the ingot cutting step 128 is wasted to prevent accumulation of impurities in the system 100. The milling, sandblasting and/or crushing step 132 also produces some waste.

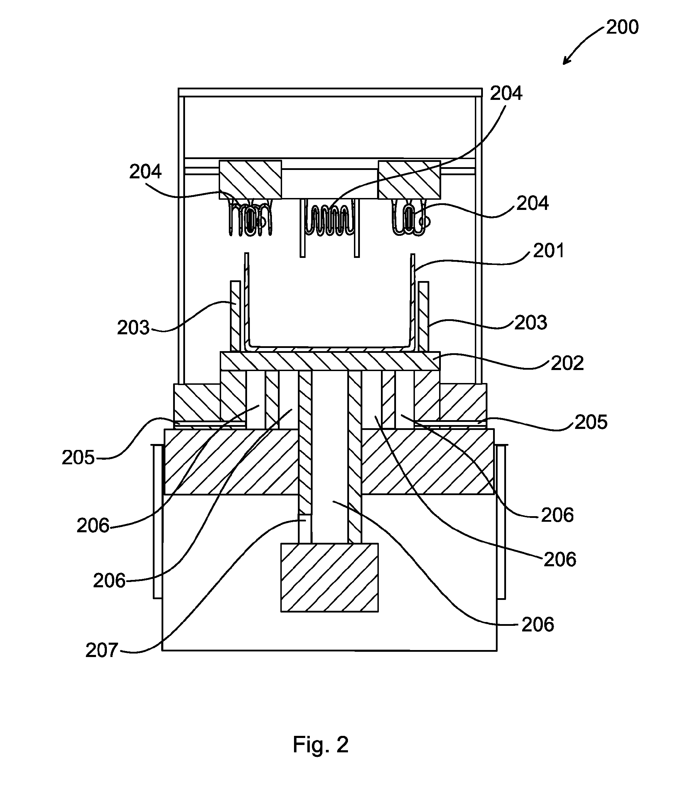

An exemplary embodiment of a furnace for carrying out a directional solidification according to the present disclosure is described below with reference to figure 2.

A crucible or a mould 201 is placed on a bottom plate 202 in the furnace. Supporting structures 203 are provided on the sides of the crucible or around the mould 201. The bottom plate 202 and the supporting structures 203 are not fixed to the furnace construction. Thus, the crucible/mould 201 may be transported in and out of the furnace 200 on the bottom plate 202. For example, the crucible/mould 201 may be preheated in another furnace placed on the bottom plate 202 and then filled with liquid silicon placed on the bottom plate 202 outside the furnace 200, before being moved into the furnace 200 on the bottom plate 202. Heating elements 204 are arranged above the crucible 201 in the furnace 200, such that liquid silicon in the crucible 201 may be heated from above. Cooling is provided below the bottom plate 202. Air acting as cooling media is supplied though air inlets 205 to cooling channels 206 provided under the bottom plate. Hot air exits through an air outlet 207.

## Claims

1. A refining method to produce solar grade silicon, wherein a silicon melt is added to a mould which is subsequently heated from above and cooled from below to generate a bottom-up solidification, **characterized in that** the bottom-up solidification is carried out in an oxygen-containing atmosphere.

2. The method according to claim 1, further comprising the step of preheating the mould to at least 1000 °C before the silicon melt is added.

3. The method according to any one of the preceding claims, wherein the addition of the silicon melt to the crucible/mould is carried out in an atmosphere of air.

4. The method according to any one of the preceding claims, wherein the liquid silicon melt is added to the mould by pouring it from a ladle or an induction furnace directly into the mould, said pouring being carried out in an atmosphere of air.

5. The method according to any one of the preceding claims, wherein the thermal conductivity through the bottom of the mould to a cooling media is at least 0.75 W/°K, such as at least 0.85 W/°K.

6. The method according to any one of the preceding claims, wherein the thermal conductivity through a side wall construction of the mould is lower than 0.80 W/°K, such as lower than 0.75 W/°K.

7. The method according to any one of the preceding claims, wherein the heating effect is at least 170 kW/m² cast area, such as at least 195 kW/m² cast area.

8. The method according to any one of the preceding claims, wherein heating elements employed for the heating can reach an element temperature of at least 1700 °C., such as at least 1800 °C, and tolerates oxygen at such a temperature.

9. The method according to any one of the preceding claims, wherein a cooling system employed for the cooling is capable of removing at least 20 kW/m² cast area in the mould.

10. The method according to any one of the preceding claims, wherein the cooling media employed for the cooling is air.

11. The method according to any one of the preceding claims, wherein the cooling media is supplied below a bottom plate arranged under the bottom of the mould.

12. The method according to any one of the preceding claims, further comprising the step of removing a top layer of the solid silicon ingot obtained from the solidification.

13. The method according to any one of the preceding claims, further comprising the step of removing side layers and a bottom layer of the solid silicon ingot obtained from the solidification.

14. The method according to claim 13, wherein the removed side layers and the bottom layer is recycled to a process of providing the silicon melt.
